# EUROPEAN PATENT SPECIFICATION

(11) **EP 4 345 003 B1**
(45) Date of publication and mention of the grant of the patent: **11.02.2026**
(21) Application number: 22198570.8
(22) Date of filing: 29.09.2022
(51) Int. Cl.: B64D 7/00, B64D 33/02, B64U 20/10, H01Q 17/00, G01S 7/38

(54) **PROPULSION SYSTEM FOR AN AERIAL VEHICLE**
ANTRIEBSSYSTEM FÜR EIN LUFTFAHRZEUG
SYSTÈME DE PROPULSION POUR UN VÉHICULE AÉRIEN

(43) Date of publication of application: 03.04.2024
(73) Proprietor: HENSOLDT Sensors GmbH, 82024 Taufkirchen (DE)
(72) Inventor: Sander, Jörg, 89075 Ulm (DE)
(74) Representative: LifeTech IP Spies & Behrndt Patentanwälte PartG mbB

(56) References cited:
- EP-A1- 3 244 054
- WO-A1-02/070342
- JP-A- 2003 300 500
- JP-A- 2007 168 491
- JP-A- 2014 070 548
- JP-A- H07 257 492
- KR-B1- 102 345 560
- US-A- 4 019 699

## Description

The present invention relates to a propulsion system for an aerial vehicle and a method for manufacturing a propulsion system and, in particular, to an aerial vehicle propulsion system with low radar observability.

### BACKGROUND

Aerial vehicles are maned or unmanned flying vehicles like airplanes, helicopters or drones and may have a propeller-based propulsion system. This provides the advantages such as a low noise emission and fuel efficiency. However, propeller-based propulsion systems provide a large cross-section for radar signals and are thus easily detectable by radar systems. There are even radar systems that are able to detect the type of aerial vehicle simply by analysing the reflected radar signals from the propellers or rotor blades. For the military use this represents a major problem, because an easy detection of aerial vehicles shall be avoided.

Document WO 02/070342 A1 discloses a circular vertical take-off and landing aircraft with a low radar profile. Document US 4 019 699 A discloses an aircraft of low observability to radar, thermal and acoustic detection devices. Document JP 2014 070548 A discloses an engine of an aircraft having a reheat apparatus with a flame holder for reflecting electromagnetic waves by radar contact.

Since also jet engines face this problem due to their rotating turbine blades that can easily be detected by radar systems, there is a demand for suppressing the radar observability of aerial vehicle.

### SUMMARY OF THE INVENTION

At least some of these problems are overcome by a propulsion system according to claim 1 and a method for manufacturing a propulsion system according to claim 6.

The present invention relates to a propulsion system for an aerial vehicle with a suppressed radar observability. The system comprising: one or more rotors with rotor blades, a fuselage, a tubular channel structure, and a shielding structure. The fuselage provides support for the one or more rotors and at least one integrated engine to drive the one or more rotors. The rotor blades protrude radially outwards from the fuselage. The tubular channel structure circumferentially extends around the fuselage and covers the protruding rotor blades. The tubular channel structure includes an inlet and an outlet between which the rotor blades are arranged to drive a propulsion airflow. The shielding structure is formed at the inlet and/or at the outlet to shield radar signals and thus to suppress radar detection of the rotor blades.

According to embodiment the aerial vehicle is manned or unmanned (e.g. a drone). The shielding structure and tubular structure may be monolithically be formed, wherein the shielding effect is achieved by a coating or by utilizing a particular form or geometry of tubular structure. The fuselage may have rotational symmetric form (e.g. as cylinder or a cigar) and may be attachable to the aerial vehicle.

The propulsion system further comprises a heat sink formed at a portion of the fuselage, where it thermally couples on the one side to the shielding structure and on the other side to the one or more integrated engine or other heat generating components within the fuselage (e.g. electronic components) to dissipate generated heat to the propulsion airflow passing through the tubular channel structure. The shielding structure may thus act as a cooling grid. The shielding structure may also extend into the fuselage to provide a direct contact to the engine or the heat generating components.

Optionally, to absorb energy of radar signals, the tubular channel structure and/or the shielding structure include(s) one or more of the following materials: a metal, a metallized polymer, carbon or a compound thereof. Metal material provides the advantage that it can very efficiently dissipate heat and can absorb energy of radar signals. The radar signal absorbing material may be formed as a coating on a base material such as a polymer.

Optionally, the shielding structure include one or more of the following: a grating or a lattice or a grid, multiple channels, a plurality of curved airducts, a stealth structure.

Optionally, the multiple channels and/or the curved airducts are formed with a predetermined geometry to attenuate a propagation of radar signals along the airflow by adjusting at least one of the following parameters:
- a cross-sectional area,
- a form of the cross-sectional area,
- at least one extension of the cross-sectional area (e.g. length, width, height, radius etc.),
- a length of the channels or the airducts.

Optionally, the one or more rotors include at least two rotors rotating in opposite rotational directions. According to further embodiments, 3, 4 or more than 5 or at least 10 rotors are included, which can be driven by one or more engines.

Embodiments relates also to a method of manufacturing a propulsion system of an aerial vehicle with a suppressed radar observability. The method comprises the features of claim 6.

As set out before, the shielding structure can be formed as gratings allowing multiple channels of airflow, or as curved air guides, or as a stealth structure with edged incident surface for the radar signals (differently inclined flat surfaces).

According to further embodiments, all features of the propulsion system as described herein can be implemented by further optional method steps.

In summary, embodiments relate propulsion systems with an open ring fuselage rotor that does not provide a large cross-section for radar signals as the conventional propeller-based propulsion systems. Embodiments achieve the suppression by a particularly formed tubular channel structure covering the rotor blades and a particular designed shield structure that prevents radar signals - when following the airflow - from any reflection from the blades of the rotors.

Thus, embodiments provide the advantage that by using a rotor-based propulsion the fuel consumption can be reduced in combination with a low noise emission of the propulsion system and an effective suppression of reflections of all radar signals at the aerial vehicle. Of particular advantage is the implementation of various shielding effects such as stealth shielding features in combination with an effective cooling mechanism.

### BRIEF DESCRIPTION OF THE DRAWINGS

Various embodiments of the present invention will be described in the following by way of examples only, and with respect to the accompanying drawings, in which:
- Fig. 1: depicts a propulsion system for an aerial vehicle according to an embodiment.
- Fig. 2: depicts embodiments for the shielding structure implemented in the propulsion system.
- Figs. 3A, 3B: depict another embodiment for the shielding structure formed as a stealth structure.
- Fig. 4: depicts yet another embodiment of the propulsion system with an integrated heat sink.
- Fig. 5: shows schematically a flow chart for a method of manufacturing the propulsion system according to embodiments.

### DETAILED DESCRIPTION

Various examples will now be described more fully with reference to the accompanying drawings in which some examples are illustrated.

Accordingly, while examples are capable of various modifications and alternative forms, the illustrative examples in the figures will herein be described in detail. It should be understood, however, that there is no intent to limit examples to the particular forms disclosed, but on the contrary, examples are to cover all modifications and alternatives falling within the scope of the appended claims.

Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing illustrative examples only and is not intended to be limiting. As used herein, the singular forms "a, " "an" and "the" are intended to include the plural forms as well, unless the context clearly indicates otherwise. It will be further understood that the terms "comprises," "comprising," "includes" and/or "including," when used herein, specify the presence of stated features, steps, operations, elements and/or components, but do not preclude the presence or addition of one or more other features, steps, operations, elements, components and/or groups thereof.

Unless otherwise defined, all terms (including technical and scientific terms) used herein have the same meaning as commonly understood by one of ordinary skill in the art to which examples belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

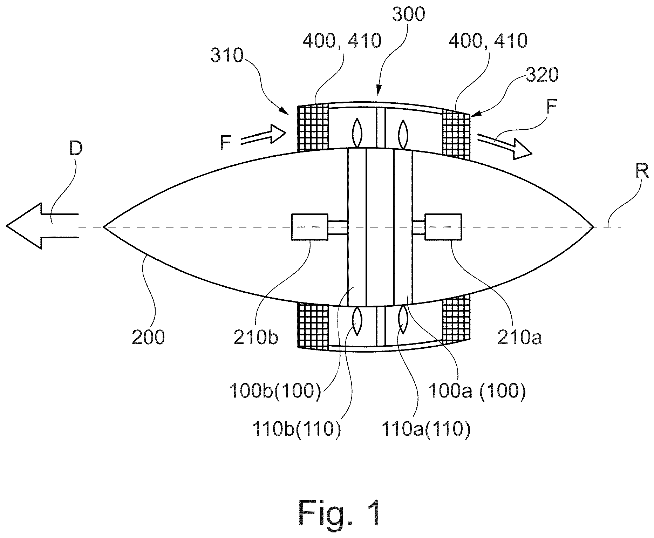

**Fig. 1** depicts a propulsion system for an aerial vehicle according to an embodiment. The propulsion system is configured to suppress radar observability and comprises rotors 100a, 100b with respective rotor blades 110a, 110b and a fuselage 200 with a support for the rotors 100a, 100b. According to the depicted embodiment, the propulsion system comprises a first rotor 100a driven by a first engine 210a and a second rotor 100b driven by a second engine 210b. According to further embodiments, only a single engine drives one or more rotors 100. The rotor(s) 100 with the rotor blades 110 and the fuselage 200 are formed so that only the rotor blades 110 protrude radially outwards from the fuselage 200. The engine(s) may be combustion engine(s) or electro motors and will move the aerial vehicle in the direction D by generating the airflow F.

The propulsion system further comprises a tubular channel structure 300 which circumferentially extends around the fuselage 200 and accommodates the protruding rotor blades 110. The tubular channel structure 300 comprises an inlet 310 and an outlet 320 between which the rotor blades 110 are arranged to drive the airflow F from the inlet 310 to the outlet 320. The inlet 310 and the outlet 320 include a respective shielding structure 400 for radar signals to prevent radar detection of the rotor blades 110.

It is understood that the cross-sectional view depicted in Fig. 1 is rotationally symmetric around the axis R so that the tubular structure 300 extends as an outer cylinder around the fuselage 200. It is further understood that the fuselage 200 may be attached to an aerial vehicle to provide the propulsion force for the aerial vehicle in the direction D.

According to embodiments, the shielding structure 400 may be formed as a grating 410 or a grating structure which extends not only in the area perpendicular to the airflow F but also along the airflow F to form a 3-dimensional (3D) grating. The grating 410 may be formed by a plurality of two-dimensional (2D) gratings which are arranged along the airflow F. The airflow F propagates through the 3D grating 410 when flowing from the inlet 310 to the outlet 320 and may be formed by a material that includes metal to absorb radar signals inside the exemplary grating structure 410.

To achieve an efficient absorption, a grating parameter may change within the grating 410 so that electromagnetic waves may easily enter the grating structure 410 but will be absorbed when propagating further along the airflow F. For example, a grating pitch or spacing may change along the airflow F. It is also possible that the multiple 2D gratings 410 have a successively lower spacing.

Furthermore, the shielding structure 400 and/or the tubular structure 300 may comprise or may be formed as a coating with radar absorbing material (RAM), which may comprise a compound of different materials such as iron, carbon, ferrite formed in geometric (micro-) structures to increase the absorption rate. Any know RAM may be employed for this purpose. The shielding structure 400 and/or the tubular structure 300 may comprise as base material a polymer which may be metallized to achieve the desired radar absorption property.

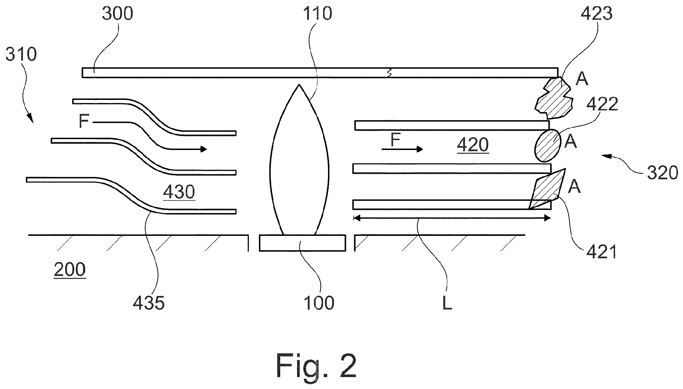

**Fig. 2** depicts another embodiment for the shielding structure 400 provided upstream and downstream from the rotor blades 110 of the rotor 100.

In this embodiment, the inlet 310 on the left-hand side comprises a shielding structure 400 formed as curved channels 430 so that channel walls 435 guide the airflow F along a curved path. There may be further channel walls which are not shown in Fig. 2 that extend parallel to the drawing plane. As result, the channels 430 may be have a rectangular cross-section perpendicular to the airflow F.

The curved path, when viewed from the front, is formed to hide the blades 110.

Thus, they may be invisible. Incoming radar signals will be reflected multiple times by the channel walls 435 before they can reach the rotor blades 110. Reflected signals will be scattered in various directions so that they will unlikely be reflected back to the inlet 310. Furthermore, the channel walls 435 may comprise a material that absorbs radar signal effectively so that each reflection will attenuate the signal and any outgoing signal will have a significant lower power when compared to the original ingoing signal.

In the depicted embodiment, the outlet 320 on the right-hand side comprises a shielding structure 400 formed as a duct structure 420 of multiple channels. Each channel of the multiple channel may provide the airflow F an area A and has a length L. The geometry of the area A can be chosen differently. It is understood that the ducts 420 may be have various geometries. For example, the cross-sectional area can form a rectangle 411 or a circle 412 or irregular 413 and they may be formed in the same way or differently.

Moreover, the geometry of each cross-sectional area 411, 412, 413 can be associated with waveguide cutoff frequency and thus allows a propagation of radio signals only with frequencies above the cutoff frequency (they are high-pass filter). Therefore, according to embodiments, the multiple channels 420 are formed with a geometry such that they filter incoming radar signals. In addition, the length L can be adjusted accordingly, because the attenuation increases with the length L. Therefore, in addition cross-sectional area 411, 412, 413, the length L may be selected such that radar signals are efficiently absorbed.

For an efficient suppression of radar signals the cross-sectional area together with the length L are such that the particular frequencies of radar signals (e.g. in the C-band, X-band, K-band etc) are highly suppressed when the signals propagate along the airflow.

In summary, embodiments relate to various possibilities for the shielding structure to suppress reflections of incoming radar signals from the blades themselves. For example, a particular form of the airduct 420 that guides the airflow F through the propulsion system reduces the radar cross-section. Furthermore, depending on the expected wavelength of the radar signal, it is possible to select a particular ratio between the length L of the airduct 420 and the cross-section 411, 412, 413 of each airduct 420. Additionally, the form or design of the inlet 310 could be selected such that no reflections of radar signals are possible.

A preferred manufacturing technology for these particular forms and shapes of the tubular channel structures 430, 420 would be the additive manufacturing which allows an accurate manufacturing of the geometry and form of the tubular channel structure 300 and/or the shielding structure 400. The additive manufacturing can use metal materials to absorb the electromagnetic energy effectively. For example, in the manufacturing process, a metallized polymer could be used as a shielding material which is suitable to absorb radar signals very efficiently in air.

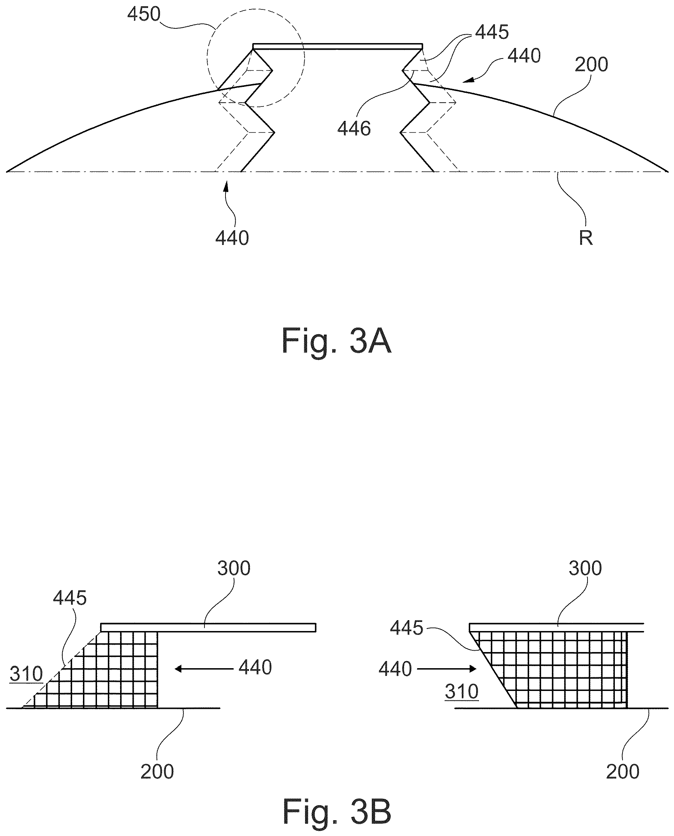

**Fig. 3A** depicts another embodiment for the shielding structure 400 which is formed as a stealth structure 440 which is characterized in that the outer surfaces 445 are flat and are joined along edges 446. This provides the technical effect that radar signals are unlikely reflected back their origin, but are scattered into other directions. For example, in the plane perpendicular to the airflow F, the inlet 310 and/or outlet 320 is formed by a plurality of flat outer surfaces 445 extending around the circumferential direction with respect to the rotational symmetry axis R.

According to embodiments, the stealth structure 440 can be formed by a triangulation using flat triangles and/or rectangles 445 which are connected with each other along edges 446. The flat surfaces 445 with sharp edges may act as transmitter to defuse incoming radar signals (scatter them away) into other directions so that they are barely detectable by a radar system. The surface normal of these flat surfaces 445 are directed into various directions to support the spreading of the scattered signals.

**Fig. 3B** shows further details of the region 450 as a cross-sectional view through a flat surface 445 representing the outer limit of the shielding structure 440. It is understood that the flat surface 445 are also not curved in the direction perpendicular to the drawing plane, i.e. they extend also in the other directions as a flat surface. Furthermore, Fig. 3B illustrates the two possible tilted flat surfaces 445 which are formed along the circumferential direction. In the radial direction, the tilted flat surface 450 can either increase along the airflow F (see left-hand side in Fig. 3B) or decreases along the flow F (see right-hand side in Fig. 3B). Different portions along the circumferential direction can be formed by either of these tilted, flat surfaces 445.

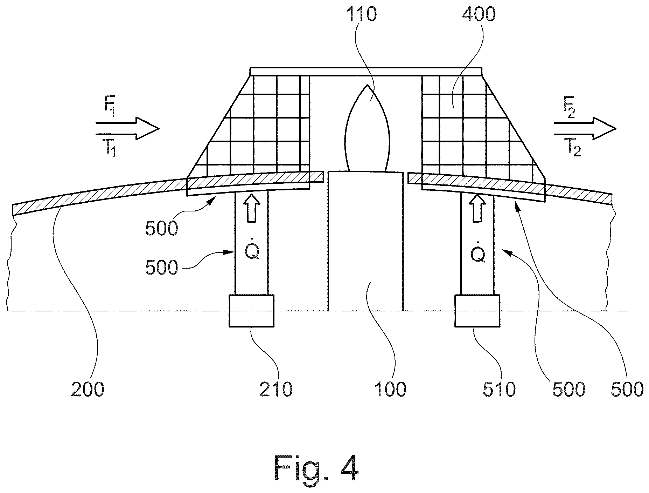

**Fig. 4** depicts another embodiment of the propulsion system, wherein a heat sink 500 is formed at a portion of the fuselage 200. The heat sink 500 couples on the one side to the shielding structure 400 (e.g. the grating 410) and on the other side with an engine 210 or another heat generating component 510 of the fuselage (e.g. an electronic equipment). The heat sink 500 may be formed by a material (e.g. metal) that efficiently transfers heat to the exemplary grating 410.

Additionally, the shielding structure 400 may extend through the fuselage 200 to get into a direct contact with the engine 210 or the heat generating component 510.

Since the incoming airflow F₁ with a temperature T₁ provides an efficient cooling of the grating 410, the coupled heat sink 500 can be used to efficiently transfer the heat Q from the engine 210 or the other component 410 to the outgoing airflow F2 higher temperature T2 than the temperature T1 of the incoming airflow F1.

Therefore, a particular advantage of embodiments relies in the fact that the shielding structure 400 can in turn be used as a cooling structure (or a cooling grid) to cool the electronic equipment 210, 510 within the fuselage 200. For example, the engine 210 can be coupled directly or indirectly to the heat sink 500 which in turn couples to the shielding structure 400 formed by a metallized polymer which allows a sufficient cooling of the propulsion motor 210 of the rotors 100.

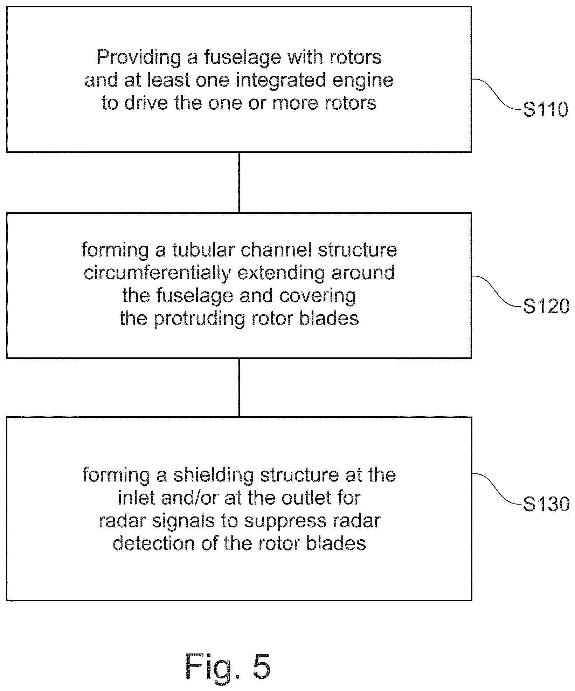

**Fig. 5** shows schematically a flow chart for a method of manufacturing the propulsion system according to embodiments. The method comprises:
- providing S110 a fuselage 200 with one or more rotors 100 and a support for at least one integrated engine 210 to drive the one or more rotors 100,
- forming S120 a tubular channel structure 300 circumferentially extending around the fuselage 200 and covering the protruding rotor blades 110, and
- forming S130 a shielding structure 400 at the inlet 310 and/or at the outlet 320 for radar signals to suppress radar detection of the rotor blades 110.

According to claim 6, the method further comprises:forming a heat sink at a portion of the fuselage (200), wherein the heat sink (500) couples thermally on the one side to the shielding structure (400) and on the other side to the one or more integrated engine (210) or heat generating components (510) of the fuselage (200) to dissipate generated heat to the propulsion airflow passing through the tubular channel structure.

It is understood that every optional features of the propulsion system can be implemented as further optional method steps.

Aspects of embodiments can be summarized as follows. The propulsion system according to embodiments represents a fuselage rotor system providing the advantage of not only being very efficient, but also having a reduced noise emission. This makes them in particular suitable for flying applications such as unmanned aerial vehicles such as drones. Furthermore, the applied shielding structures 400 covers the negative stealth properties of otherwise open rotors which can barely be detected through the shielding structure 400.

The description and drawings merely illustrate the principles of the disclosure. It will thus be appreciated that those skilled in the art will be able to devise various arrangements that, although not explicitly described or shown herein, embody the principles of the disclosure and are included within the scope of the appended claims.

Furthermore, while each embodiment may stand on its own as a separate example, it is to be noted that in other embodiments the defined features can be combined differently, i.e. a particular feature descripted in one embodiment may also be realized in other embodiments. Such combinations are covered by the disclosure herein unless it is stated that a specific combination is not intended. Although the invention has been illustrated and described in detail by way of preferred embodiments, the invention is not limited by the examples disclosed, and other variations can be derived from these by the person skilled in the art without leaving the scope of the invention. It is therefore clear that there is a plurality of possible variations. It is also clear that embodiments stated by way of example are only really examples that are not to be seen as limiting the scope, application possibilities or configuration of the invention in any way. In fact, the preceding description and the description of the figures enable the person skilled in the art to implement the exemplary embodiments in concrete manner, wherein, with the knowledge of the disclosed inventive concept, the person skilled in the art is able to undertake various changes, for example, with regard to the functioning or arrangement of individual elements stated in an exemplary embodiment without leaving the scope of the invention, which is defined by the claims, such as further explanations in the description.

### List of reference signs

| | |
|---|---|
| 100 | rotors |
| 110 | rotor blades |
| 200 | fuselage |
| 210 | driving engine |
| 300 | tubular channel structure |
| 310 | inlet |
| 320 | outlet |
| 400 | shielding structure |
| 410 | 3D grating/lattice structure |
| 420 | plurality of airducts |
| 411, 412, 413 | different cross-sections of the airducts |
| 430 | curved airducts |
| 435 | channel walls of the airducts |
| 440 | stealth structure |
| 445 | flat surfaces of a stealth structure |
| 446 | edges of a stealth structure |
| 500 | heat sink |
| 510 | other heat generating components (e.g. electronic equipment) |
| D | flying direction |
| L | length of channels |
| R | rotational symmetry axis |
| F, F1,F2 | airflow (incoming, outcoming) |
| T1,T2 | temperature of airflows |
| Q | dissipated heat |

## Claims

1. A propulsion system for an aerial vehicle with a suppressed radar observability, the system comprising:
one or more rotors (100) with rotor blades (110);
a fuselage (200) with a support for the one or more rotors (100) and at least one integrated engine (210) to drive the one or more rotors (100),
wherein the rotor blades (110) protrude radially outwards from the fuselage (200);
a tubular channel structure (300) circumferentially extending around the fuselage (200) and covering the protruding rotor blades (110), wherein
the tubular channel structure (300) includes an inlet (310) and an outlet (320) between which the rotor blades (110) are arranged to drive a propulsion airflow (F);
a shielding structure (400) at the inlet (310) and/or at the outlet (320) for radar signals to suppress radar detection of the rotor blades (110),
the propulsion system further comprising:
a heat sink (500) formed at a portion of the fuselage (200), wherein the heat sink (500) couples thermally on the one side to the shielding structure (400) and on the other side to the one or more integrated engine (210) or heat generating components (510) within the fuselage (200) to dissipate generated heat to the propulsion airflow (F) passing through the tubular channel structure (300).

2. The propulsion system according to claim 1, wherein, to absorb energy of radar signals, the tubular channel structure (300) and/or the shielding structure (400) include one or more of the following materials: a metal, a metallized polymer, carbon or a compound thereof.

3. The propulsion system according to claim 1 or claim 2, wherein the shielding structure (400) include one or more of the following:
- a grating or lattice or grid (410),
- multiple channels (420),
- a plurality of curved airducts (430),
- a stealth structure (440).

4. The propulsion system according to claim 3, wherein the multiple channels (420) and/or the curved airducts (430) are formed with a predetermined geometry to attenuate a propagation of radar signals along the airflow (F) by adjusting at least one of the following parameters:
- a cross-sectional area (A),
- a form of the cross-sectional area (421, 422, 423),
- at least one extension of the cross-sectional area,
- a length (L) of the channels (420) or the airducts (430).

5. The propulsion system according to any one of claims 1 to 4, wherein the one or more rotors (100) include at least two rotors rotating in opposite rotational directions.

6. A method of manufacturing a propulsion system of an aerial vehicle with a suppressed radar observability, the method comprising:
providing (S110) a fuselage (200) with one or more rotors (100) and at least one integrated engine (210) to drive the one or more rotors (100), wherein rotor blades (110) of the one or more rotors (100) protrude radially outwards from the fuselage (200);
forming (S120) a tubular channel structure (300) circumferentially extending around the fuselage (200) and covering the protruding rotor blades (110), wherein the tubular channel structure (300) includes an inlet (310) and an outlet (320) between which the rotor blades (110) are arranged to drive a propulsion air flow (F); and
forming (S130) a shielding structure (400) at the inlet (310) and/or at the outlet (320) for radar signals to suppress radar detection of the rotor blades (110); and
forming a heat sink (500) at a portion of the fuselage (200),
wherein the heat sink (500) couples thermally on the one side to the shielding structure (400) and on the other side to the one or more integrated engine (210) or heat generating components (510) within the fuselage (200) to dissipate generated heat to the propulsion airflow (F) passing through the tubular channel structure (300).

## Patentansprüche

1. Antriebssystem für ein Luftfahrzeug mit einer unterdrückten Radarsichtbarkeit, das System umfassend:
einen oder mehrere Rotoren (100) mit Rotorblättern (110);
einen Rumpf (200) mit einer Halterung für den einen oder die mehrere Rotoren (100) und mindestens einem integrierten Triebwerk (210), um den einen oder die mehreren Rotoren (100) anzutreiben, wobei die Rotorblätter (110) radial nach außen aus dem Rumpf (200) herausragen;
eine rohrförmige Kanalstruktur (300), die sich in Umfangsrichtung um den Rumpf (200) herum erstreckt und die herausragenden Rotorblätter (110) bedeckt, wobei die rohrförmige Kanalstruktur (300) einen Einlass (310) und einen Auslass (320) einschließt, zwischen denen die Rotorblätter (110) angeordnet sind, um einen Antriebsluftstrom (F) anzutreiben;
eine Abschirmstruktur (400) an dem Einlass (310) und/oder an dem Auslass (320) für Radarsignale, um eine Radarerfassung der Rotorblätter (110) zu unterdrücken, das Antriebssystem ferner umfassend:
einen Kühlkörper (500), der an einem Abschnitt des Rumpfes (200) ausgebildet ist, wobei der Kühlkörper (500) an der einen Seite mit der Abschirmstruktur (400) und an der anderen Seite mit dem einen oder den mehreren integrierten Triebwerken (210) oder wärmeerzeugenden Komponenten (510) innerhalb des Rumpfes (200) thermisch gekoppelt ist, um die erzeugte Wärme an den Antriebsluftstrom (F), der durch die rohrförmige Kanalstruktur (300) verläuft, abzuführen.

2. Antriebssystem nach Anspruch 1, wobei, um Energie von Radarsignalen zu absorbieren, die rohrförmige Kanalstruktur (300) und/oder die Abschirmstruktur (400) eines oder mehrere der folgenden Materialien einschließen: ein Metall, ein metallisiertes Polymer, Kohlenstoff oder eine Verbindung davon.

3. Antriebssystem nach Anspruch 1 oder 2, wobei die Abschirmstruktur (400) eines oder mehrere der Folgenden einschließt:
- ein Gitter oder ein Gitterwerk oder ein Raster (410),
- mehrere Kanäle (420),
- eine Vielzahl von gekrümmten Luftkanälen (430),
- eine getarnte Struktur (440).

4. Antriebssystem nach Anspruch 3, wobei die mehreren Kanäle (420) und/oder die gekrümmten Luftkanäle (430) mit einer vorbestimmten Geometrie ausgebildet sind, um eine Ausbreitung von Radarsignalen entlang des Luftstroms (F) durch Anpassen mindestens eines der folgenden Parameter zu dämpfen:
- eine Querschnittsfläche (A),
- eine Form der Querschnittsfläche (421, 422, 423),
- mindestens eine Erstreckung der Querschnittsfläche,
- eine Länge (L) der Kanäle (420) oder der Luftkanäle (430).

5. Antriebssystem nach einem der Ansprüche 1 bis 4, wobei der oder die Rotoren (100) mindestens zwei Rotoren einschließen, die sich in entgegengesetzten Drehrichtungen drehen.

6. Verfahren zum Herstellen eines Antriebssystems eines Luftfahrzeugs mit einer unterdrückten Radarsichtbarkeit, das Verfahren umfassend:
Bereitstellen (S110) eines Rumpfes (200) mit einem oder mehreren Rotoren (100) und mindestens einem integrierten Triebwerk (210), um den einen oder die mehreren Rotoren (100) anzutreiben, wobei Rotorblätter (110) des einen oder der mehreren Rotoren (100) radial nach außen aus dem Rumpf (200) herausragen;
Ausbilden (S120) einer rohrförmigen Kanalstruktur (300), die sich in Umfangsrichtung um den Rumpf (200) herum erstreckt und die herausragenden Rotorblätter (110) bedeckt, wobei die rohrförmige Kanalstruktur (300) einen Einlass (310) und einen Auslass (320) einschließt, zwischen denen die Rotorblätter (110) angeordnet sind, um einen Antriebsluftstrom (F) anzutreiben; und
Ausbilden (S130) einer Abschirmstruktur (400) an dem Einlass (310) und/oder an dem Auslass (320) für Radarsignale, um die Radarerfassung der Rotorblätter (110) zu unterdrücken; und
Ausbilden eines Kühlkörpers (500) an einem Abschnitt des Rumpfes (200),
wobei der Kühlkörper (500) an der einen Seite mit der Abschirmstruktur (400) und an der anderen Seite mit dem einen oder den mehreren integrierten Triebwerken (210) oder wärmeerzeugenden Komponenten (510) innerhalb des Rumpfes (200) thermisch gekoppelt ist, um die erzeugte Wärme an den Antriebsluftstrom (F), der durch die rohrförmige Kanalstruktur (300) verläuft, abzuführen.

## Revendications

1. Système de propulsion pour un véhicule aérien avec une observabilité radar réduite, le système comprenant :
un ou plusieurs rotors (100) avec des pales de rotor (110) ;
un fuselage (200) avec un support pour le ou les rotors (100) et au moins un moteur intégré (210) pour entraîner le ou les rotors (100), dans lequel les pales de rotor (110) font saillie radialement vers l'extérieur à partir du fuselage (200) ;
une structure de canal tubulaire (300) s'étendant circonférentiellement autour du fuselage (200) et recouvrant les pales de rotor saillantes (110), dans lequel la structure de canal tubulaire (300) comporte une entrée (310) et une sortie (320) entre lesquelles les pales de rotor (110) sont agencées pour entraîner un flux d'air de propulsion (F) ;
une structure de blindage (400) au niveau de l'entrée (310) et/ou de la sortie (320) pour des signaux radar afin de supprimer la détection radar des pales de rotor (110), le système de propulsion comprenant en outre :
un dissipateur thermique (500) formé au niveau d'une partie du fuselage (200), dans lequel le dissipateur thermique (500) se couple thermiquement d'un côté à la structure de blindage (400) et de l'autre côté au ou aux moteurs intégrés (210) ou à des composants générateurs de chaleur (510) à l'intérieur du fuselage (200) pour dissiper la chaleur générée dans le flux d'air de propulsion (F) passant à travers la structure de canal tubulaire (300).

2. Système de propulsion selon la revendication 1, dans lequel, pour absorber l'énergie de signaux radar, la structure de canal tubulaire (300) et/ou la structure de blindage (400) comportent un ou plusieurs des matériaux suivants : un métal, un polymère métallisé, du carbone ou un composés de ceux-ci.

3. Système de propulsion selon la revendication 1 ou la revendication 2, dans lequel la structure de blindage (400) comporte un ou plusieurs parmi les suivants :
- une grille ou un treillis ou un quadrillage (410),
- de multiples canaux (420),
- une pluralité de conduits d'air incurvés (430),
- une structure furtive (440).

4. Système de propulsion selon la revendication 3, dans lequel les multiples canaux (420) et/ou les conduits d'air incurvés (430) sont formés avec une géométrie prédéterminée pour atténuer une propagation de signaux radar le long du flux d'air (F) en ajustant au moins l'un des paramètres suivants :
- une section transversale (A),
- une forme de la section transversale (421, 422, 423),
- au moins une extension de la section transversale,
- une longueur (L) des canaux (420) ou des conduits d'air (430).

5. Système de propulsion selon l'une quelconque des revendications 1 à 4, dans lequel le ou les rotors (100) comportent au moins deux rotors tournant dans des directions de rotation opposées.

6. Procédé de fabrication d'un système de propulsion d'un véhicule aérien avec une observabilité radar réduite, le procédé comprenant :
la fourniture (S110) d'un fuselage (200) avec un ou plusieurs rotors (100) et au moins un moteur intégré (210) pour entraîner le ou les rotors (100), dans lequel des pales de rotor (110) du ou des rotors (100) font saillie radialement vers l'extérieur à partir du fuselage (200) ;
la formation (S120) d'une structure de canal tubulaire (300) s'étendant circonférentiellement autour du fuselage (200) et recouvrant les pales de rotor saillantes (110), dans lequel la structure de canal tubulaire (300) comporte une entrée (310) et une sortie (320) entre lesquelles les pales de rotor (110) sont agencées pour entraîner un flux d'air de propulsion (F) ; et
la formation (S130) d'une structure de blindage (400) au niveau de l'entrée (310) et/ou de la sortie (320) pour des signaux radar afin de supprimer la détection radar des pales de rotor (110) ; et
la formation d'un dissipateur thermique (500) au niveau d'une partie du fuselage (200),
dans lequel le dissipateur thermique (500) se couple thermiquement d'un côté à la structure de blindage (400) et de l'autre côté au ou aux moteurs intégrés (210) ou à des composants générateurs de chaleur (510) à l'intérieur du fuselage (200) pour dissiper la chaleur générée dans le flux d'air de propulsion (F) passant à travers la structure de canal tubulaire (300).
